# EUROPÄISCHE PATENTSCHRIFT

(11) **EP 0 363 626 B1**
(45) Veröffentlichungstag und Bekanntmachung des Hinweises auf die Patenterteilung: **31.03.1993**
(21) Anmeldenummer: 89116225.7
(22) Anmeldetag: 02.09.1989
(51) Int. Cl.: H03K 19/0175

(54) **Schaltungsanordnung zur Pegelumsetzung digitaler Signale**
Digital signal level conversion circuit arrangement
Circuit de conversion de niveau pour signaux numériques

(30) Priorität: 23.09.1988 DE 3832378
(43) Veröffentlichungstag der Anmeldung: 18.04.1990
(73) Patentinhaber: EUROSIL electronic GmbH, D-85386 Eching (DE)
(72) Erfinder: Firth, Stephen P., Near Cardiff South Wales (GB)
(74) Vertreter: Maute, Hans-Jürgen, Dipl.-Ing.

(56) Entgegenhaltungen:
- DE-A- 2 363 735
- US-A- 4 102 491
- US-A- 4 623 799
- US-A- 4 791 312
- IBM TECHNICAL DISCLOSURE BULLETIN, Band 24, Nr. 7A, Dezember 1981, Seiten 3165-3166, New York, US; D.A. PARRY: "Programmable bipolar driver"
- R.J. HIGGINS "Electronics with Digital and Analog Integrated Circuits", 1983, PRENTICE-HALL, Englewood Cliffs, N.J., Seiten 532 - 534.

## Beschreibung

Die Erfindung betrifft eine Schaltungsanordnung zur Pegelumsetzung digitaler Signale gemäß dem Oberbegriff des Anspruches 1.

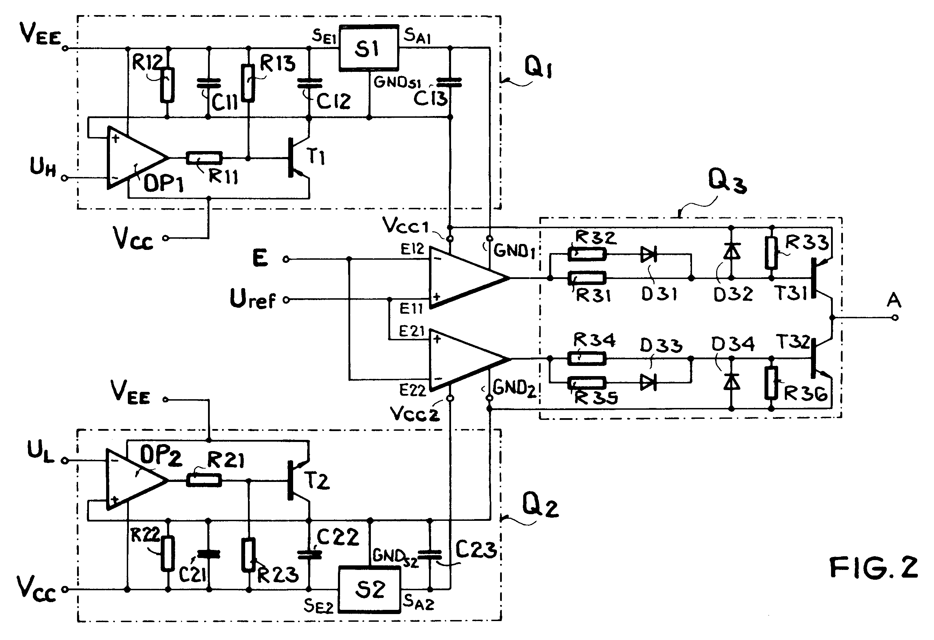

Derartige Schaltungen werden beispielsweise in digitalen Systemen als Koppelglied zwischen zwei Schaltkreisfamilien mit unterschiedlichen logischen Pegeln verwendet. Beispielsweise setzt die Pinelektronik eines IC-Testsystems ein TTL- oder ein ECL-Eingangssignal auf ein anderes Signal mit programmierbarem Spannungshub und Spannungsbereich um, das an den Prüfling gelegt wird. Eine solche Pinelektronik-Schaltung ist aus dem "Referenz-Manual" der Fairchild Camera and Instrument Corporation, Publication Number 57 11 0004, March 1983, ECO Number 11991, Seite 2 - 14, Fig. 2 - 7 bekannt.

Diese bekannte Schaltung enthält zwei miteinander verbundene Diodenbrücken, die jeweils an einem ersten Referenzpotential und einem zweiten Referenzpotential angeschlossen sind, die dem High-Pegel bzw. Low-Pegel der umgesetzten Digitalsignale entsprechen. An zwei weiteren Anschlüssen wird jeweils das umzusetzende Digitalsignal bzw. ein Referenzsignal angelegt, während am Verbindungspunkt der beiden Diodenbrücken das Ausgangssignal der Schaltung abgreifbar ist. In Abhängigkeit des an den Eingang angelegten Pegels wird eine der beiden Diodenbrücken von einem Konstantstrom durchflossen, der von einer Konstantstromquelle erzeugt ist. Hierdurch gelangt das entsprechende Referenzpotential an den Verbindungspunkt der beiden Diodenbrücken, der mit dem Prüfling verbunden ist.

Ein Nachteil dieser bekannten Schaltung besteht in einem großen Energieverbrauch, da ständig durch eine der beiden Diodenbrücken ein Konstantstrom fließt, der auch sehr groß ist, um eine hohe Schaltgeschwindigkeit der Schaltung zu gewährleisten.

Aus R. J. Higgins "Electronics with Digital and Analog Integrated Circuits", 1983, PRENTICE-HALL, Englewood Cliffs, N. J. , Seiten 532 - 534, insbesondere Figur 19.5 auf Seite 534 ist eine Schaltungsanordnung bekannt, die einen ersten und einen zweiten Komparator aufweist. Beide Komparatoren verfügen jeweils über einen ersten und zweiten Eingang und jeweils einen Ausgang zur Steuerung einer mit dem Ausgangsanschluß der Schaltung verbundenen Endstufe. Bei dieser bekannten Schaltungsanordnung wird dem invertierenden Eingang des einen Komparators und dem nicht-invertierenden Eingang des anderen Komparators ein Eingangssignal zugeführt. Dem jeweils anderen Eingang wird jeweils eine erste und eine zweite Referenzspannung zugeführt, so daß die Schaltungsanordnung als Fensterkomparator arbeitet. Wenn die Eingangsspannung innerhalb eines bestimmten Bereichs liegt, wird der Ausgang der Schaltungsanordnung mittels der Endstufe auf ein erstes Potential gelegt. Sonst liegt der Ausgang der Schaltungsanordnung auf einem zweiten Potential.

Aufgabe der Erfindung ist es eine Schaltungsanordnung der eingangs genannten Art zu schaffen, die einen geringen Energieverbrauch aufweist und einen einfachen Aufbau erlaubt.

Diese Aufgabe wird durch den kennzeichnenden Teil des Anspruches 1 gelöst.

Vorteilhafte Ausgestaltungen und Weiterbildungen der Erfindung sind den abhängigen Ansprüchen zu entnehmen.

Im folgenden wird die Erfindung anhand eines Ausführungsbeispieles unter Bezugnahme auf die Zeichnungen genauer beschrieben. Es zeigt:
- Figur 1: ein Blockschaltbild einer erfindungsgemäßen Schaltungsanordnung,
- Figur 2: eine schaltungstechnische Ausführung der erfindungsgemäßen Schaltung gemäß Figur 1, und
- Figur 3a und 3b: Impulsdiagramme von umzusetzenden und umgesetzten Digitalsignalen.

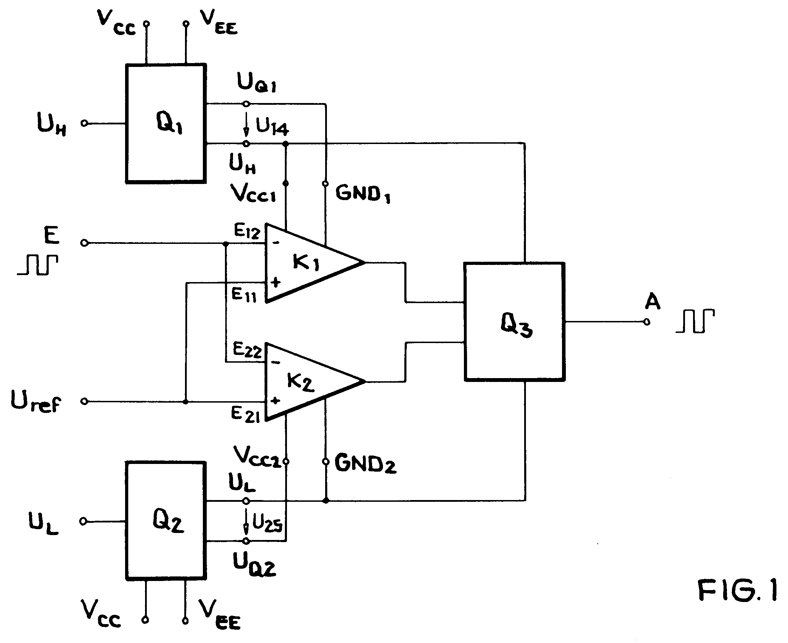

Die Figur 1 zeigt eine Schaltungsanordnung mit zwei als Komparatoren arbeitenden Leitungsempfänger K₁ und K₂, deren Ausgänge mit einer Endstufe Q₃, die einen Ausgang A aufweist, verbunden sind. Die nicht-invertierenden bzw. invertierenden Eingänge E₁₁ und E₂₁ bzw. E₁₂ und E₂₂ sind jeweils verbunden und an ein Referenzpotential (drittes Potential) U_{ref} bzw. an den Eingang E der Schaltung angeschlossen.

Ferner weist diese erfindungsgemäße Schaltung zwei Spannungsversorgungseinheiten Q₁ und Q₂ auf, an die außer den beiden Betriebsspannungsquellen V_{CC} und V_{EE} jeweils ein erstes und zweites Potential U_{H} und U_{L} angelegt ist. Diese beiden Spannungsversorgungseinheiten erzeugen jeweils ein viertes und fünftes Potential U_{Q1} und U_{Q2}, so daß an deren Ausgängen neben diesem vierten und fünften Potential U_{Q1} und U_{Q2} auch das erste und zweite Potential U_{H} und U_{L} abgreifbar sind, wobei diese Potentiale U_{H} und U_{L} auch an die Endstufe Q₃ weitergeleitet werden.

Das von der ersten Spannungsversorgungseinheit Q₁ erzeugte vierte Potential U_{Q1} ist kleiner als das von ihr an ihrem Ausgang durchgeschaltete erste Potential U_{H} und weist immer den gleichen Abstand zu diesem Potential auf, das heißt, das vierte Potential wird so erzeugt, daß die Potentialdifferenz U_{H} - U_{Q1} = U₁₄ immer konstant ist. Diese Spannung U_{₁₄} dient als Betriebsspannung für den ersten Leitungsempfänger K₁, indem das erste Potential U_{H} auf den Betriebsspannungsanschluß V_{CC1} und das vierte Potential U_{Q1} auf den Bezugspotentialanschluß GND₁ gelegt ist.

In gleicher Art und Weise erzeugt die zweite Spannungsversorgungseinheit Q₂ mit Hilfe des fünften Potentials U_{Q2}, das größer als das zweite Potential U_{L} ist, eine konstante Potentialdifferenz U_{Q2} - U_{L} = U₂₅, die ebenfalls als Betriebsspannungsquelle für den zweiten Leitungsempfänger K₂ eingesetzt ist. Hierbei ist das fünfte Potential U_{Q2} an den Betriebsspannungsanschluß V_{CC2} und das zweite Potential U_{L} an den Bezugspotentialanschluß GND₂ gelegt. Somit können die beiden Leitungsempfänger K₁ und K₂ mit niedriger Spannung versorgt werden, um den Energieverbrauch zu minimieren.

Am Ausgang A der erfindungsgemäßen Schaltung gemäß Figur 1 stehen die umgesetzten Signale zur Verfügung, wobei deren Signalpegel - High-Pegel und Low-Pegel - von dem den Spannungsversorgungseinheiten Q₁ und Q₂ zugeführten ersten und zweiten Potential U_{H} und U_{L} abhängen.

Wenn dem Eingang E beispielsweise TTL-Signale zur Umsetzung zugeführt werden, liegt das Referenzpotential (drittes Potential) U_{ref} zwischen dem höchsten TTL-Signalpegel und dem niedrigsten. Liegt nun am Eingang E ein High-Pegel, so steuern die beiden Leitungsempfänger K₁ und K₂ die Endstufe Q₃ derart an, daß auf dem Ausgang A das erste Potential U_{H} geschaltet wird. Liegt umgekehrt ein Low-Pegel am Eingang E, wird der Ausgang A auf das zweite Potential U_{L} gelegt.

Somit lassen sich alle digitalen Eingangssignale in entsprechende digitale Ausgangssignale umsetzen, deren Signalpegel in weiten Bereichen durch das erste und zweite Potential bestimmbar sind.

Die Figur 2 zeigt die schaltungstechnische Ausführung der beiden Spannungsversorgungseinheiten Q₁ und Q₂ sowie der Endstufe Q₃, wobei die beiden Leitungsempfänger K₁ und K₂ gemäß der Figur 1 verschaltet sind.

Die Spannungsversorgungseinheit Q₁ bzw. Q₂ besteht aus einem Operationsverstärker OP₁ bzw. OP₂, einem pnp-bzw. npn-Transistor T₁ bzw. T₂, einem Spannungsregler S₁ bzw. S₂, jeweils drei Widerständen R₁₁ bis R₁₃ bzw. R₂₁ bis R₂₃ und jeweils drei Kondensatoren C₁₁ bis C₁₃ bzw. C₂₁ bis C₂₃.

Der nicht-invertierende bzw. invertierende Eingang des Operationsverstärkers OP₁ bzw. OP₂ ist mit der Kollektorelektrode des pnp- bzw. npn-Transistors T₁ bzw. T₂ verbunden bzw. an das erste bzw. zweite Potential U_{H} bzw. U_{L} angeschlossen, während dessen Ausgang über jeweils einen ersten Widerstand R₁₁ bzw. R₂₁ mit der Basiselektrode des pnp- bzw. npn-Transistors T₁ bzw. T₂ verbunden ist. Die Emitterelektroden des Transistors T₁ bzw. T₂ liegen auf dem Potential der ersten bzw. zweiten Betriebsspannungsquelle V_{CC} bzw. V_{EE}. Jeweils der zweite Widerstand R₁₂ bzw. R₂₂ sowie jeweils die ersten und zweiten Kondensatoren C₁₁ und C₁₂ bzw. C₂₁ und C₂₂ verbinden die Kollektorelektrode des Transistors T₁ bzw. T₂ mit der zweiten bzw. ersten Betriebsspannungsquelle V_{EE} bzw. V_{CC}, während jeweils der dritte Widerstand R₁₃ bzw. R₂₃ die Basiselektrode des pnp- bzw. npn-Transistors T₁ bzw. T₂ mit der zweiten bzw. ersten Betriebsspannungsquelle V_{EE} bzw. V_{CC} verbindet. Der Spannungsregler S₁ bzw. S₂ ist mit seinem Eingang S_{E1} bzw. S_{E2} an die zweite bzw. erste Betriebsspannungsquelle V_{EE} bzw. V_{CC} angeschlossen, während sein Ausgang S_{A1} bzw. S_{A2} über jeweils den dritten Kondensator C₁₃ bzw. C₂₃ mit jeweils seinem Betriebspotentialanschluß GND_{S1} bzw. GND_{S2} verbunden ist, der gleichzeitig an der Kollektorelektrode des pnp- bzw. npn-Transistors T₁ bzw. T₂ liegt. Der jeweilige Ausgang S_{A1} bzw. S_{A2} des Spannungsreglers S₁ bzw. S₂, der jeweils das vierte und fünfte Potential U_{Q1} bzw. U_{Q2} liefert, ist mit dem Bezugspotentialanschluß GND₁ bzw. mit dem Betriebsspannungsanschluß V_{CC1} des ersten bzw. des zweiten Leitungsempfängers K₁ bzw. K₂ verbunden. Schließlich bildet jeweils die Kollektorelektrode des Transistors T₁ bzw. T₂, die auf dem ersten bzw. zweiten Potential U_{H} bzw. U_{L} liegt, die Anschlußelektrode für die Betriebsspannung V_{CC1} bzw. für das Bezugspotential GND₂ des ersten bzw. zweiten Leitungsempfängers K₁ bzw. K₂.

Die Endstufe Q₃ enthält einen pnp- und npn-Endstufentransistor T₃₁ und T₃₂, vier Dioden D₃₁ bis D₃₄ und sechs Widerstände R₃₁ bis R₃₆. Die beiden Kollektorelektroden der Endstufentransistoren T₃₁ und T₃₂ sind verbunden und bilden den Ausgangsanschluß der Schaltungsanordnung. Die beiden Widerstände R₃₁ und R₃₄ als auch die beiden Serienschaltungen aus dem Widerstand R₃₂ und der Diode D₃₁ und aus dem Widerstand R₃₅ und der Diode D₃₃ verbinden jeweils die Basiselektrode des Transistors T₃₁ und des Transistors T₃₂ mit jeweils den Ausgängen der beiden Leitungsempfänger K₁ und K₂, wobei die Diode D₃₁ bzw. D₃₃ kathodenseitig mit der Basiselektrode des Transistors T₃₁ bzw. T₃₂ verbunden ist. Schließlich sind jeweils die Emitterelektroden der Endstufentransistoren T₃₁ bzw. T₃₂ über die Diode D₃₂ und D₃₄ als auch über die Widerstände R₃₃ und R₃₆ mit deren Basiselektroden verbunden, hierbei ist die Anode bzw. Kathode der Diode D₃₂ bzw. D₃₄ an die Basiselektrode des Endstufentransistors T₃₁ bzw. T₃₂ angeschlossen. Ferner sind jeweils die Emitterelektroden der Endstufentransistoren T₃₁ und T₃₂ zur Übertragung des ersten und zweiten Potentials U_{H} und U_{L} an die Kollektorelektrode des Transistors T₁ bzw. T₂ der ersten bzw. zweiten Spannungsversorgungseinheit Q₁ bzw. Q₂ angeschlossen.

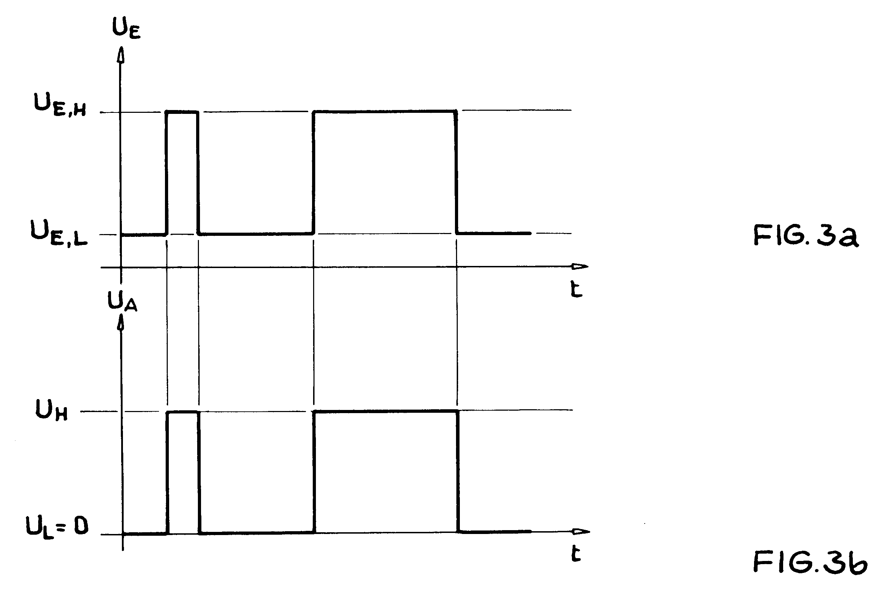

Nun soll im folgenden die Funktion dieser Schaltung gemäß der Figur 2 erläutert werden, wobei wieder angenommen werden soll, daß dem Eingang E die beispielsweise in Figur 3a dargestellten TTL-Signale zur Umsetzung zugeführt werden. Hierbei betrage der High-Pegel U_{E,H} ca. 2,4 V und der Low-Pegel U_{E,L} ca. 0,8 V. Die Figur 3b zeigt beispielhaft eine umgesetzte Signalfolge, wobei der High-Pegel U_{H} 1,5 V und der Low-Pegel O V beträgt. Diese beiden Pegel entsprechen den beiden Spannungsversorgungseinheiten Q₁ bzw. Q₂ jeweils zugeführten Potentiale U_{H} und U_{L}. Das Referenzpotential U_{ref} beträgt ca. 1,4 V.

Liegt am Eingang E ein Low-Pegel von 0,8 V an, so schalten die als Komparatoren arbeitenden beiden Leitungsempfänger K₁ und K₂ ihre Ausgänge auf maximale Ausgangsspannung. Diese Schaltflanke wird jeweils über das Widerstands-Dioden-Netzwerk auf die Basiselektrode des Endstufentransistors T₃₁ bzw. T₃₂ übertragen. Da diese Transistoren entgegengesetzten Leitfähigkeitstyp aufweisen, sperrt der Endstufentransistor T₃₁, während der Endstufentransistor T₃₂ in den leitenden Zustand übergeht. Hierdurch wird das auf dem Emitter des Endstufentransistors T₃₂ liegende zweite Potential U_{L} auf die Kollektorelektrode durchgeschaltet, so daß am Ausgang A das gewünschte Low-Signal erscheint. Wird umgekehrt ein High-Pegel von ca. 2,4 V an den Eingang E gelegt, schalten die beiden Leitungsempfänger K₁ und K₂ ihre Ausgänge auf minimale Ausgangsspannung, wodurch der Endstufentransistor T₃₁ in den leitenden und der Endstufentransistor T₃₂ in den sperrenden Zustand übergeht. Durch den Endstufentransistor T₃₁ wird jetzt das erste Potential U_{H} auf dessen Kollektorelektrode geschaltet, das damit am Ausgang A zur Verfügung steht.

Die beiden Spannungsversorgungseinheiten Q₁ und Q₂ sind identisch aufgebaut und unterscheiden sich nur in den Polaritäten und den Leitfähigkeitstypen der Transistoren, weshalb auch deren Funktionen einander gleich sind. Es soll daher beispielhaft nur die Funktion der ersten Spannungsversorgungseinheit Q₁ erläutert werden, da hieraus die Funktion der zweiten Spannungsversorgungseinheit Q₂ unter Beachtung der genannten Unterschiede leicht abgeleitet werden kann.

Der Operationsverstärker OP₁ regelt den Verstärkertransistor T₁ derart, daß sich an der Kollektorelektrode das erste Potential U_{H} einstellt, wobei der Widerstand R₁₂ der Kollektorwiderstand des Transistors ist und mit den beiden Widerständen R₁₁ und R₁₃ sein Arbeitspunkt eingestellt wird.

Der Spannungsregler S₁ erzeugt in Abhängigkeit des an seinem Bezugspotentialanschluß GND_{S1} anliegenden ersten Potential U_{H} ein viertes Potential U_{Q1}, das beispielsweise um 5 V niedriger als das erste Potential U_{H} ist. Diese Potentialdifferenz dient als Betriebsspannung für den ersten Leitungsempfänger K₁, wobei diese Spannung jedoch immer auf einem konstanten Wert unabhängig von demjenigen des ersten Potentials U_{H} bleibt. Der erste Kondensator C₁₁ wirkt als Filter, während der zweite Kondensator C₁₂ zur Stabilisierung der Eingangsspannung V_{EE} dient. Schließlich unterdrückt der dritte Kondensator C₁₃ kurze und hohe Spannungsspitzen (Transienten).

Im Gegensatz zum Spannungsregler S₁ erzeugt der Spannungsregler S₂ der zweiten Spannungsversorgungseinheit Q₂ ein fünftes Potential U_{Q2}, das beispielsweise um 5 V höher als das zweite Potential U_{L} ist. Somit ist gewährleistet, daß an dem Betriebsspannungsanschluß V_{CC1} bzw. V_{CC2} des ersten Leitungsempfängers K₂ bzw. des zweiten Leitungsempfängers K₂ immer gegenüber dem Bezugspotentialanschluß GND₁ bzw. GND₂ eine konstante Spannung anliegt, beispielsweise für beide Leitungsempfänger 5 V.

Die Schaltflanken am Ausgang der Leitungsempfänger K₁ bzw. K₂ werden über ein Widerstands-Schottky-Dioden-Netzwerk auf die Basiselektrode des Transistors T₃₁ bzw. T₃₂ übertragen. Der Widerstand R₃₁ bzw. R₃₄ dient zur Einstellung der Arbeitspunkte des Transistors T₃₁ bzw. T₃₂. Die diese Widerstände jeweils überbrückende Serienschaltung aus dem Widerstand R₃₂ und der Diode D₃₁ bzw. dem Widerstand R₃₅ und der Diode D₃₃ verkürzt die Anstiegszeiten der Schaltflanken. Der Widerstand R₃₃ bzw. R₃₆ gewährleistet ein sicheres Sperren des Transistors T₃₁ bzw. T₃₂, während mit der Diode D₃₂ bzw. D₃₄ ein sicherer Übergang vom leitenden in den sperrenden Zustand des Transistors T₃₁ bzw. T₃₂ erzielbar ist.

Die erfindungsgemäße Schaltungsanordnung wurde mit diskreten Bauteilen gemäß der folgenden Stückliste aufgebaut, wobei für die beiden Leitungsempfänger K₁ und K₂ ein Vierfach-Differential-Leitungsempfänger AM26LS33 von Advanced Micro Devices eingesetzt wurde und der Spannungsregler S₁ ein Negativ-Spannungsregler MC7905C und der Spannungsregler S₂ ein Positiv-Spannungsregler MC78T05 von Motorola ist.

| | |
|---|---|
| R₁₁ = 10 kΩ | R₃₁ = 7,5 kΩ |
| R₁₂ = 10 kΩ | R₃₂ = 150 Ω |
| R₁₃ = 2,7 kΩ | R₃₃ = 2,7 kΩ |
| R₂₁ = 10 kΩ | R₃₄ = 7,5 kΩ |
| R₂₂ = 10 kΩ | R₃₅ = 150 Ω |
| R₂₃ = 2,7 kΩ | R₃₆ = 2,7 kΩ |

| | |
|---|---|
| C₁₁ = 1 µF | D₃₁ = BYS-21-45 |
| C₁₂ = 2,2 µF | D₃₂ = 1N 6263 |
| C₁₃ = 1 µF | D₃₃ = BYS-21-45 |
| C₂₁ = 1 µF | D₃₄ = 1N 6263 |
| C₂₂ = 2,2 µF | |
| C₂₃ = 1 µF | |

| | |
|---|---|
| T₁ = BD 148 | OP₁ = LM 741 |
| T₂ = BD 137 | OP₂ = LM 741 |
| T₃₁ = 2N 3985 | |
| T₃₂ = 2N 3983 | |

Diese erfindungsgemäße Schaltungsanordnung kann in vorteilhafter Weise als Pinelektronik-Schaltung in einem IC-Tester eingesetzt werden, wobei sich diese Pinelektronik durch einen niedrigen Stromverbrauch von nur 35 mA pro Pin bei einer 10 MHz-Testrate und einem Spannungshub von 20 V auszeichnet. Hierbei sind zwei Betriebsspannungen von + 15 V (V_{CC}) und - 15 V (V_{EE}) notwendig. Bei einem Spannungshub von 5 V erreicht die Schaltung eine Testrate von 30 MHz. Der maximale Pin-zu-Pin-Skew beträgt ± 1,5 ns, während die Ausgangsimpedanz der beiden Endstufentransistoren T₃₁ und T₃₂ der Endstufe Q₃ einen Wert von 50 Ω aufweist.

## Patentansprüche

1. Schaltungsanordnung zur Pegelumsetzung digitaler Signale, welche an ein erstes, zweites und drittes Potential (U_{H}, U_{L}, U_{ref}) gelegt ist und die ihren Ausgang (A) entsprechend einem an ihrem Eingang (E) zugeführten Signalpegel auf das erste oder zweite Potential (U_{H}, U_{L}) legt, mit einem ersten und einem zweiten als Komparator betriebenen Leitungsempfänger (K₁, K₂) mit jeweils einem ersten und einem zweiten Eingang (E₁₁, E₁₂, E₂₁, E₂₂) und jeweils einem Ausgang zur Steuerung einer mit dem Ausgang (A) der Schaltungsanordnung verbundenen Endstufe (Q₃), dadurch gekennzeichnet, daß die ersten Eingänge (E₁₁, E₂₁) der beiden Leitungsempfänger (K₁, K₂) an das dritte Potential (U_{ref}) und die zweiten Eingänge (E₁₂, E₂₂) an den Eingang (E) der Schaltungsanordnung gelegt sind, daß eine erste Spannungsversorgungseinheit (Q₁) aus dem ihr zugeführten ersten Potential (U_{H}) ein viertes Potential (U_{Q1}) erzeugt, das eine erste konstante Potentialdifferenz (U₁₄) mit dem ersten Potential (U_{H}) bildet, daß eine zweite Spannungsversorgungseinheit (Q₂) aus dem ihr zugeführten zweiten Potential (U_{L}) ein fünftes Potential (U_{Q2}) erzeugt, das eine zweite konstante Potentialdifferenz (U₂₅) mit dem zweiten Potential (U_{L}) bildet, daß die erste Potentialdifferenz (U₁₄) dem ersten Leitungsempfänger (K₁) und die zweite Potentialdifferenz (U₂₅) dem zweiten Leitungsempfänger (K₂) als Betriebsspannung den jeweiligen Betriebsspannungsanschlüssen zugeführt wird.

2. Schaltungsanordnung nach Anspruch 1 dadurch gekennzeichnet, daß das dritte Potential (U_{ref}) zwischen dem höchsten und dem niedrigsten Eingangssignalpegel liegt.

3. Schaltungsanordnung nach Anspruch 1 oder 2, dadurch gekennzeichnet, daß das vierte Potential (U_{Q1}) kleiner als das erste Potential (U_{H}) und das fünfte Potential (U_{Q2}) größer als das zweite Potential (U_{L}) ist.

4. Schaltungsanordnung nach einem der vorangehenden Ansprüche, dadurch gekennzeichnet, daß die Werte der beiden Potentialdifferenzen (U₁₄, U₂₅) übereinstimmen.

5. Schaltungsanordnung nach einem der vorangehenden Ansprüche, dadurch gekennzeichnet, daß die Endstufe (Q₃) mit der ersten und der zweiten Spannungsversorgungseinheit (Q₁, Q₂) zur Übertragung des ersten und des zweiten Potentials verbunden ist.

6. Schaltungsanordnung nach einem der vorangehenden Ansprüche, dadurch gekennzeichnet, daß der Spannungshub der dem Eingang (E) zugeführten Signalpegel den Wert der von den beiden Spannungsversorgungseinheiten (Q₁, Q₂) erzeugten Potentialdifferenzen (U₁₄, U₂₅) übersteigt.

7. Schaltungsanordnung nach einem der vorangehenden Ansprüche, dadurch gekennzeichnet, daß die erste und zweite Spannungsversorgungseinheit (Q₁, Q₂) jeweils einen Spannungsregler (S₁, S₂) zur Erzeugung des vierten und fünften Potentials enthält.

8. Schaltungsanordnung nach einem der vorangehenden Ansprüche, dadurch gekennzeichnet, daß die nicht-invertierenden und die invertierenden Eingänge (E₁₁, E₂₁), (E₁₂, E₂₂) der beiden Leitungsempfänger (K₁ K₂) verbunden sind, daß die nicht-invertierenden Eingänge an das dritte Potential (U_{ref}) und die invertierenden Eingänge an den Eingang (E) der Schaltungsanordnung gelegt sind.

9. Schaltungsanordnung nach einem der vorangehenden Ansprüche, dadurch gekennzeichnet, daß die erste bzw. zweite Spannungsversorgungseinheit (Q₁ bzw. Q₂) folgende Elemente enthält:
a) einen ersten bzw. zweiten Operationsverstärker (OP₁, OP₂), dessen invertierender Eingang mit dem ersten bzw. zweiten Potential (U_{H,} U_{L}) verbunden ist,
b) einen pnp- bzw. npn-Transistor (T₁ , T₂) , dessen Kollektorelektrode mit dem nicht-invertierenden Eingang des ersten bzw. zweiten Operationsverstärkers (OP₁, OP₂) verbunden ist, dessen Emitterelektrode auf dem Potential einer ersten bzw. zweiten Betriebsspannungsquelle (V_{CC}, V_{EE}) liegt und dessen Basiselektrode über jeweils einen ersten Widerstand (R₁₁, R₂₁) an dem Ausgang des ersten bzw. zweiten Operationsverstärkers (OP₁ , OP₂) angeschlossen ist,
c) jeweils einen zweiten Widerstand (R₁₂ bzw. R₂₂), der zwischen dem nicht-invertierenden Eingang des ersten bzw. zweiten Operationsverstärkers (OP₁, OP₂) und der zweiten bzw. ersten Betriebsspannungsquelle (V_{EE}, V_{CC}) angeordnet ist,
d) jeweils einen ersten und Zweiten Kondensator (C₁₁, C₁₂ bzw. C₂₁, C₂₂), die jeweils den Pol der zwei-ten bzw. ersten Betriebsspannungsquelle (V_{EE}, V_{CC}) mit der Kollektorelektrode des pnp- bzw. npn-Transistors (T₁, T₂) verbinden,
e) jeweils einen dritten Widerstand (R₁₃ bzw. R₂₃), der die Basiselektrode des pnp- bzw. npn-Transistors (T₁, T₂) mit dem Potential der zweiten bzw. ersten Betriebsspannungsquelle (V_{EE}, V_{CC}) verbindet,
f) einen ersten bzw. zweiten Spannungsregler (S₁, S₂), dessen Eingang (S_{E1} bzw. S_{E2}) mit der Zweiten bzw. ersten Betriebsspannungsquelle (V_{EE}, V_{CC}) verbunden ist, dessen Bezugspotentialanschluß (GND_{S1} bzw. GND_{S2}) sowohl an die Kollektorelektrode des pnp- bzw. npn-Transistors (T₁, T₂) als auch an den Betriebsspannungsanschluß (V_{CC1}) bzw. an den Bezugspotentialanschluß (GND₂) des ersten bzw. zweiten Leitungsempfängers (K₁, K₂) angeschlossen ist und dessen Ausgang (S_{A1} bzw. S_{A2}) mit dem Bezugspotentialanschluß (GND_{K1}) bzw. des Betriebsspannungsanschlusses (V_{CC2}) des ersten bzw. zweiten Leitungsempfängers (K₁, K₂) verbunden ist,
g) jeweils einen dritten Kondensator (C₁₃ bzw. C₂₃), der den Ausgangsanschluß (S_{A1} bzw. S_{A2}) des ersten bzw. zweiten Spannungsreglers (S₁, S₂) mit dessen Bezugspotentialanschluß (GND₁ bzw. GND₂) verbindet.

10. Schaltungsanordnung nach einem der vorangehenden Ansprüche, dadurch gekennzeichnet, daß die Endstufe (Q₃) folgende Elemente enthält:
a) einen ersten pnp-Endstufentransistor (T₃₁), dessen Basiselektrode über einen ersten Widerstand (R₃₁) mit dem Ausgang des ersten Leitungsempfängers (K₁) verbunden ist, und dessen Emitterelektrode an den Betriebsspannungsanschluß (V_{CC1}) des ersten Leitungsempfängers (K₁) angeschlossen ist,
b) einen zweiten Widerstand (R₃₂) und eine erste Diode (D₃₁), die in Serie geschaltet sind und den Ausgang des ersten Leitungsempfängers (K₁) mit der Basiselektrode des ersten Endstufentransistors (T₃₁) verbinden, wobei die Kathode der ersten Diode (D₃₁) an die Basiselektrode des ersten Endstufentransistors (T₃₁) angeschlossen ist und deren Anode mit dem zweiten Widerstand (R₃₂) verbunden ist,
c) einen dritten Widerstand (R₃₃) und eine zweite Diode (D₃₂) zum jeweiligen Verbinden der Basiselektrode des ersten Endstufentransistors (T₃₁) mit dessen Emitterelektrode, wobei die Kathode der zweiten Diode (D₃₂) an die Emitterelektrode des ersten Endstufentransistors (T₃₁) angeschlossen ist und deren Anode an dessen Basiselektrode,
d) einen zweiten npn-Endstufentransistor (T₃₂), dessen Basiselektrode über einen vierten Widerstand (R₃₄) mit dem Ausgang des zweiten Leitungsempfängers (K₂) verbunden ist, dessen Emitterelektrode an den Bezugspotentialanschluß (GND₂) des zweiten Leitungsempfängers (K₂) angeschlossen ist, und dessen Kollektorelektrode mit der Kollektorelektrode des ersten Endstufentransistors (T₃₁) als auch mit dem Ausgang (A) verbunden ist,
e) einen fünften Widerstand (R₃₅) und eine dritte Diode (D₃₃), die in Serie geschaltet sind und den Ausgang des zweiten Leitungsempfängers (K₂) mit der Basiselektrode des zweiten Endstufentransistors (T₃₂) verbinden, wobei die Kathode der dritten Diode (D₃₃) an den fünften Widerstand (R₃₅) angeschlossen ist und deren Anode mit der Basiselektrode des zweiten Endstufentransistors (T₃₂) verbunden ist,
f) einen sechsten Widerstand (R₃₆) und eine vierte Diode (D₃₄) zum jeweiligen Verbinden der Basiselektrode des zweiten Endstufentransistors (T₃₂) mit dessen Kollektorelektrode, wobei die Kathode der vierten Diode (D₃₄) an die Basiselektrode des zweiten Endstufentransistors (T₃₂) angeschlossen ist und deren Anode an dessen Emitterelektrode.

## Claims

1. Circuit arrangement for the conversion of the level of digital signals which is connected to a first, second and third potential (U_{H}, U_{L}, U_{ref}) and which sets its output (A) in accordance with a signal level supplied to its input (E) at the first or second potential (U_{H}, U_{L}), including a first and a second line receiver (K₁ , K₂ ) driven as comparators having respectively a first and a second input (E₁₁, E₁₂, E₂₁, E₂₂) and a respective output for the control of an output stage (Q₃) connected to the output (A) of the circuit arrangement, characterised in that, the first inputs (E₁₁, E₂₁) of the two line receivers (K₁ , K₂) are connected to the third potential (U_{ref}) and the two inputs (E₁₂, E₂₂) are connected to the input (E) of the circuit arrangement, that a first voltage supply unit (Q₁) produces from the first potential (U_{H}) supplied to it, a fourth potential (U_{Q1}) which forms a first constant potential difference (U₁₄) with the first potential (U_{H}), that a second voltage supply unit (Q₂) produces from the second potential (U_{L}) supplied to it a fifth potential (U_{Q2}), which forms a second constant potential difference (U₂₅) with the second potential (U_{L}), that the first potential difference (U₁₄) is supplied to the first line receiver (K₁) and the second potential difference (U₂₅) to the second line receiver (K₂) as operating voltage at the respective operating voltage terminals.

2. Circuit arrangement in accordance with claim 1, characterised in that, the third potential (U_{ref}) lies between the highest and the lowest input signal level.

3. Circuit arrangement in accordance with claim 1 or 2, characterised in that, the fourth potential (U_{Q1}) is smaller than the first potential (U_{H}) and the fifth potential (U_{Q2}) is greater than the second potential (U_{L}).

4. Circuit arrangement in accordance with any of the preceding claims, characterised in that, the values of the two potential differences (U₁₄, U₂₅) are equal.

5. Circuit arrangement in accordance with any of the preceding claims, characterised in that, the output stage (Q₃) is connected to the first and to the second voltage supply unit (Q₁, Q₂) for the transmission of the first and the second potential.

6. Circuit arrangement in accordance with any of the preceding claims, characterised in that, the voltage step of the signal levels supplied to the input (E) exceeds the value of the potential differences (U₁₄, U₂₅) produced by the two voltage supply units (Q₁, Q₂).

7. Circuit arrangement in accordance with any of the preceding claims, characterised in that, the first and second voltage supply unit (Q₁, Q₂) contains a respective voltage regulator (S₁, S₂) for the production of the fourth and fifth potentials.

8. Circuit arrangement in accordance with any of the preceding claims, characterised in that, the non-inverting and the inverting inputs (E₁₁ , E₂₁), (E₁₂ , E₂₂) of the two line receivers (K₁ , K₂) are connected, that the non-inverting inputs are set at the third potential (U_{ref}) and the inverting inputs are connected to the input (E) of the circuit arrangement.

9. Circuit arrangement in accordance with any of the preceding claims, characterised in that, the first or second voltage supply unit (Q₁ or Q₂) contains the following elements:
a) a first or second operational amplifier (OP₁, OP₂) whose inverting input is connected to the first or second potential (U_{H}, U_{L}),
b) a pnp or npn transistor (T₁ , T₂) whose collector electrode is connected to the non-inverting input of the first or second operational amplifier (OP₁, OP₂), whose emitter electrode is at the potential of a first or second operating voltage source (V_{CC}, V_{EE}) and whose base electrode is connected to the output of the first or second operational amplifier (OP₁, OP₂) via a respective first resistor (R₁₁, R₂₁),
c) a respective second resistor (R₁₂ , R₂₂) is arranged between the non-inverting input of the first or second operational amplifier (OP₁, OP₂) and the second or first operating voltage source (V_{EE}, V_{CC}),
d) a respective first and second capacitor (C₁₁, C₁₂ or C₂₁, C₂₂) which connect the pole of the second or first operating voltage source (V_{EE}, V_{CC}) to the collector electrode of the pnp or npn transistor (T₁, T₂),
e) a respective third resistor (R₁₃ or R₂₃) which connects the base electrode of the pnp or npn transistor (T₁, T₂) to the potential of the second or first operating voltage source (V_{EE}, V_{CC}),
f) a first or second voltage regulator (S₁, S₂) whose input (S_{E1} or S_{E2}) is connected to the second or first operating voltage source (V_{EE} , V_{CC}), whose reference potential terminal (GND_{S1} or GND_{S2}) is connected both to the collector electrode of the pnp or npn transistor (T₁, T₂) as well as to the operating voltage terminal (V_{CC1}) or to the reference potential terminal (GND₂) of the first or second line receiver (K₁, K₂) and whose output (S_{A1} or S_{A2}) is connected to the reference potential terminal (GHD_{K1}) or the operating voltage terminal (V_{CC2}) of the first or second line receiver (K₁, K₂),
g) a respective third capacitor (C₁₃ or C₂₃) which connects the output terminal (S_{A1} or S_{A2}) of the first or second voltage regulator (S₁, S₂) to its reference potential terminal (GND₁ or GND₂).

10. Circuit arrangement in accordance with any of the preceding claims, characterised in that, the output stage (Q₃) contains the following elements:
a) a first pnp output stage transistor (T₃₁) whose base electrode is connected to the output of the first line receiver (K₁) via a first resistor (R₃₁) and whose emitter electrode is connected to the operating voltage terminal (V_{CC1}) of the first line receiver (K₁),
b) a second resistor (R₃₂) and a first diode (D₃₁) which are connected in series and connect the output of the first line receiver (K₁) to the base electrode of the first output stage transistor (T₃₁), wherein the cathode of the first diode (D₃₁) is connected to the base electrode of the first output stage transistor (T₃₁) and its anode is connected to the second resistor (R₃₂),
c) a third resistor (R₃₃) and a second diode (D₃₂) for respectively connecting the base electrode of the first output stage transistor (T₃₁) with its emitter electrode, wherein the cathode of the second diode (D₃₂) is connected to the emitter electrode of the first output stage transistor (T₃₁) and its anode to its base electrode,
d) a second npn output stage transistor (T₃₂) whose base electrode is connected to the output of the second line receiver (K₂) via a fourth resistor (R₃₄), whose emitter electrode is connected to the reference potential terminal (GND₂) of the second line receiver (K₂) and whose collector electrode is connected to the collector electrode of the first output stage transistor (T₃₁) as well as to the output (A),
e) a fifth resistor (R₃₅) and a third diode (D₃₃) which are connected in series and connect the output of the second line receiver (K₂) to the base electrode of the second output stage transistor (T₃₂), wherein the cathode of the third diode (D₃₃) is connected to the fifth resistor (R₃₅) and its anode is connected to the base electrode of the second output stage transistor (T₃₂),
f) a sixth resistor (R₃₆) and a fourth diode (D₃₄) for respectively connecting the base electrode of the second output stage transistor (T₃₂) with its collector electrode, wherein the cathode of the fourth diode (D₃₄) is connected to the base electrode of the second output stage transistor (T₃₂) and its anode to its emitter electrode.

## Revendications

1. Circuit de conversion de niveau pour signaux numériques, auquel sont appliqués un premier, un deuxième et un troisième potentiel (U_{H}, U_{L}, U_{ref}) et qui fait passer sa sortie (A) au premier ou au deuxième potentiel (U_{H}, U_{L}) suivant le niveau de signal amené à son entrée (E), comprenant un premier et un second récepteur de ligne (K₁, K₂) utilisés comme comparateur et possédant chacun une première et une seconde entrée (E₁₁, E₁₂, E₂₁, E₂₂) et une sortie pour commander un étage final (Q₃) relié à la sortie (A) du circuit, caractérisé en ce que les premières entrées (E₁₁, E₂₁) des deux récepteurs de ligne (K₁, K₂) sont reliées au troisième potentiel (U_{ref}) et les secondes entrées (E₁₂, E₂₂) sont connectées à l'entrée (E) du circuit, qu'une première unité d'alimentation (Q₁) génère, à partir du premier potentiel (U_{H}) qui lui est amené, un quatrième potentiel (U_{Q1}) formant une première différence de potentiel constante (U₁₄) avec le premier potentiel (U_{H}), qu'une seconde unité d'alimentation (Q₂) génère, à partir du deuxième potentiel (U_{L}) qui lui est amené, un cinquième potentiel (U_{Q2}) formant une seconde différence de potentiel (U₂₅) constante avec le deuxième potentiel (U_{L}), que la première différence de potentiel (U₁₄) est amenée en tant que tension de fonctionnement aux bornes de tension de fonctionnement du premier récepteur de ligne (K₁) et que la seconde différence de potentiel (U₂₅) est amenée en tant que tension de fonctionnement aux bornes de tension de fonctionnement du second récepteur de ligne (K₂).

2. Circuit selon la revendication 1, caractérisé en ce que le troisième potentiel (U_{ref}) est compris entre le niveau le plus haut et le niveau le plus bas du signal d'entrée.

3. Circuit selon la revendication 1 ou 2, caractérisé en ce que le quatrième potentiel (U_{Q1}) est inférieur au premier potentiel (U_{H}), et le cinquième potentiel (U_{Q2}) est supérieur au deuxième potentiel (U_{L}).

4. Circuit selon une des revendications précédentes, caractérisé en ce que les valeurs des deux différences de potentiel (U₁₄, U₂₅) concordent.

5. Circuit selon une des revendications précédentes, caractérisé en ce que l'étage final (Q₃) est relié à la première et à la seconde unité d'alimentation (Q₁, Q₂) en vue de la transmission du premier et du deuxième potentiel.

6. Circuit selon une des revendications précédentes, caractérisé en ce que l'excursion de tension du niveau de signal amené à l'entrée (E) dépasse la valeur des différences de potentiel (U₁₄, U₂₅) générées par les deux unités d'alimentation (Q₁, Q₂).

7. Circuit selon une des revendications précédentes, caractérisé en ce que la première et la seconde unité d'alimentation (Q₁, Q₂) contiennent chacune un régulateur de tension (S₁, S₂) pour générer respectivement le quatrième et le cinquième potentiel.

8. Circuit selon une des revendications précédentes, caractérisé en ce que les entrées non inverseuses (E₁₁, E₂₁) des deux récepteurs de ligne (K₁, K₂) sont reliées entre elles et au troisième potentiel (U_{ref}) et que les entrées inverseuses (E₁₂, E₂₂) de ces récepteurs sont reliées entre elles et à l'entrée (E) du circuit.

9. Circuit selon une des revendications précédentes, caractérisé en ce que la première et la seconde unité d'alimentation (Q₁, Q₂) contiennent chacune les éléments suivants:
a) un premier ou un second amplificateur opérationnel (OP₁, OP₂) dont l'entrée inverseuse est reliée au premier ou au deuxième potentiel (U_{H}, U_{L}),
b) un transistor pnp ou un transistor npn (T₁, T₂) dont l'électrode de collecteur est reliée à l'entrée non inverseuse du premier ou du second amplificateur opérationnel (OP₁, OP₂), dont l'électrode d'émetteur se trouve au potentiel d'une première ou d'une seconde source de tension de fonctionnement (V_{CC}, V_{EE}) et dont l'électrode de base est raccordée à travers une première résistance (R₁₁, R₂₁) à la sortie du premier ou du second amplificateur opérationnel (OP₁, OP₂),
c) une deuxième résistance (R₁₂, R₂₂) disposée entre l'entrée non inverseuse du premier ou du second amplificateur opérationnel (OP₁, OP₂) et la seconde ou la Première source de tension de fonctionnement (V_{EE}, V_{CC}),
d) un premier et un deuxième condensateur (C₁₁, C₁₂; C₂₁, C₂₂) reliant respectivement le pôle de la seconde ou de la première source de tension de fonctionnement (V_{EE}, V_{CC}) à l'électrode de collecteur du transistor pnp ou du transistor npn (T₁, T₂),
e) une troisième résistance (R₁₃, R₂₃) qui relie l'électrode de base du transistor pnp ou du transistor npn (T₁, T₂) au potentiel de la seconde ou de la première source de tension de fonctionnement (V_{EE}, V_{CC}),
f) un premier ou un second régulateur de tension (S₁, S₂) dont l'entrée (S_{E1} ou S_{E2}) est reliée à la seconce ou à la première source de tension de fonctionnement (V_{EE}, V_{CC}), dont la borne de potentiel de référence (GND_{S1} ou GND_{S2}) est raccordée à la fois à l'électrode de collecteur du transistor pnp ou du transistor npn (T₁, T₂) et à la borne de tension de fonctionnement (V_{CC1}) ou à la borne de potentiel de référence (GND₁) du premier ou du second récepteur de ligne (K₁, K₂), et dont la sortie (S_{A1} ou S_{A2}) est reliée à la borne de potentiel de référence (GND_{S1}) ou à la borne de tension de fonctionnement (V_{CC2}) du premier ou du second récepteur de ligne (K₁, K₂) et
g) un troisième condensateur (C₁₃, C₂₃) reliant la borne de sortie (S_{A1} ou S_{A2}) du premier ou du second régulateur de tension (S₁, S₂) à sa borne de potentiel de référence (GND₁ ou GND₂).

10. Circuit selon une des revendications précédentes, caractérisé en ce que l'étage final (Q₃) contient les éléments suivants:
a) un premier transistor pnp d'étage final (T₃₁) dont l'électrode de base est reliée à travers une première résistance (R₃₁) à la sortie du premier récepteur de ligne (K₁) et dont l'électrode d'émetteur est reliée à la borne de tension de fonctionnement (V_{CC1}) du premier récepteur de ligne (K₁),
b) une deuxième résistance (R₃₂) et une première diode (D₃₁) montées en série et reliant la sortie du premier récepteur de ligne (K₁) à l'électrode de base du premier transistor d'étage final (T₃₁), la cathode de la première diode (D₃₁) étant connectée à l'electrode de base du premier transistor de base final (T₃₁) et son anode étant connectée à la deuxième résistance (R₃₂),
c) une troisième résistance (R₃₃) et une deuxième diode (D₃₂) pour relier l'électrode de base du premier transistor d'étage final (T₃₁) à l'électrode d'émetteur de celui-ci, la cathode de la deuxième diode (D₃₂) étant connectée à l'électrode d'émetteur du premier transistor d'étage final (T₃₁) et son anode étant connectée à l'électrode de base de ce transistor,
d) un deuxième transistor npn d'étage final (T₃₂) dont l'électrode de base est reliée à travers une quatrième résistance (R₃₄) à la sortie du second récepteur de ligne (K₂), dont l'électrode d'émetteur est raccordée à la borne de potentiel de référence (GND₂) du second récepteur de ligne (K₂), et dont l'électrode de collecteur est raccordée à la fois à l'électrode de collecteur du premier transistor d'étage final (T₃₁) et à la sortie (A),
e) une cinquième résistance (R₃₅) et une troisième diode (D₃₃) montées en série et reliant la sortie du second récepteur de ligne (K₂) à l'électrode de base du second transistor d'étage final (D₃₂), la cathode de la troisième diode (D₃₃) étant connectée à la cinquième résistance (R₃₅) et son anode étant connectée à l'électrode de base du second transistor d'étage final (D₃₂) et
f) une sixième résistance (R₃₆) et une quatrième diode (D₃₄) pour relier l'électrode de base du second transistor d'étage final (T₃₂) à l'électrode de collecteur de celui-ci, la cathode de la quatrième diode (D₃₄) étant connectée à l'électrode de base du second transistor d'étage final (D₃₂) et son anode étant connectée à l'électrode d'émetteur de ce transistor.
